# EUROPÄISCHE PATENTSCHRIFT

(11) **EP 2 692 057 B1**
(45) Veröffentlichungstag und Bekanntmachung des Hinweises auf die Patenterteilung: **10.05.2017**
(21) Anmeldenummer: 12712605.0
(22) Anmeldetag: 15.03.2012
(51) Int. Cl.: H03G 3/30

(54) **VORRICHTUNGEN ZUM AUTOMATISCHEN EINSTELLEN EINES VERSTÄRKUNGS- BZW. DÄMPFUNGSFAKTORS**
DEVICES FOR AUTOMATICALLY ADJUSTING AN AMPLIFYING OR ATTENUATING FACTOR
DISPOSITIF DE RÉGLAGE AUTOMATIQUE D'UN FACTEUR D'AMPLIFICATION OU D'ATTÉNUATION

(30) Priorität: 31.03.2011 DE 102011006566
(43) Veröffentlichungstag der Anmeldung: 05.02.2014
(73) Patentinhaber: Rohde & Schwarz GmbH & Co. KG, 81671 München (DE)
(72) Erfinder: KUHWALD, Thomas, 85570 Markt Schwaben (DE); VALTEN, Thomas, 82008 Unterhaching (DE)
(74) Vertreter: Körfer, Thomas
(86) Internationale Anmeldenummer: PCT/EP2012/054576
(87) Internationale Veröffentlichungsnummer: WO 2012/130625

(56) Entgegenhaltungen:
- EP-A2- 0 410 629
- WO-A2-00/59110
- GB-A- 2 179 810
- US-A- 4 456 889
- US-B1- 6 977 976

## Beschreibung

Die Erfindung betrifft eine Vorrichtung zum automatischen Einstellen eines Verstärkungs- bzw. Dämpfungsfaktors von kaskadierten Verstärkungs- und/oder Dämpfungsgliedern.

Die Eingangsstufe von modernen Funkgeräten weist typischerweise eine sehr hohe Eingangsdynamik auf, um Funksignale in einer möglichst großen Reichweite zu empfangen. Diese Eingangsdynamik einer Eingangsstufe übersteigt in der Regel den Dynamikbereich von Signalverarbeitungseinheiten in Funkgeräten wie beispielsweise Filtern oder Analog-Digital-Wandlern. Um dennoch eine hohe Dynamik anbieten zu können, werden automatische Verstärkungsregelungen (automatic gain control AGC) verwendet.

Aus der JP 2004-080455 A geht eine Signalverarbeitungsstrecke mit mehreren kaskadierten und hinsichtlich ihres Verstärkungsfaktors einstellbaren Verstärkern hervor, deren Verstärkungsfaktor jeweils mittels einer auf einer Rückkopplungs-Struktur (Feed-back-Struktur) basierenden Regelung eingestellt wird.

Die US 6 977 976 B1 offenbart eine Vorrichtung zum Filtern und Verstärken von Signalen und eine Vorrichtung gemäss dem Oberbegriff von Anspruch 1. Die WO 00/59110 A2 zeigt eine Vorrichtung zum automatischen Anpassen der Lautsprecher- und Mikrofonverstärkung eines Mobiltelefons; Die GB 2 179 810 A offenbart eine Vorrichtung zur Steuerung des Dynamikbereichs eines Signals.

Da eine rückgekoppelte Regelungsstruktur im allgemeinen ein schlechteres Einschwingverhalten und damit eine schlechtere zeitliche Dynamik aufweist und da moderne Funkgeräte in einem Frequenzsprungverfahren mit vergleichsweise kurzen Zeitschlitzen für die Nachrichtenübertragung betrieben werden, eignet sich eine derartige automatische Verstärkungsregelung für die im Signalpfad eines Funkgerät angeordneten Verstärker nur bedingt. Hinzu kommt, dass eine Regelungsstruktur strukturbedingt zu instabilen Verhalten neigen kann, was für eine sichere Nachrichtenübertragung z.B. im Flugfunk nicht akzeptabel ist.

Aufgabe der Erfindung ist es deshalb, eine Vorrichtung mit einer automatischen Verstärkungs- bzw. Dämpfungssteuerung für im Signalpfad eines Funkgeräts angeordnete Verstärkungs- bzw. Dämpfungsglieder zu entwickeln, die ein optimales Zeitverhalten aufweist.

Die Aufgabe wird er durch eine Vorrichtung zum automatischen Einstellen eines Verstärkungs- bzw. Dämpfungsfaktors von mehreren in Kaskade verschalteten Verstärkungsgliedern oder von mehreren in Kaskade verschalteten Verstärkungs- und Dämpfungsgliedern mit den Merkmalen des Patentanspruchs 1 gelöst. Vorteilhafte technische Erweiterungen sind in den einzelnen abhängigen Patentansprüchen aufgeführt.

Die Vorrichtung zum automatischen Einstellen eines Verstärkungs- bzw. Dämpfungsfaktors von mehreren in Kaskade verschalteten Verstärkungsgliedern oder von mehreren in Kaskade verschalteten Verstärkungs- und Dämpfungsgliedern weist für jedes Verstärkungs- bzw. Dämpfungsglied jeweils einen Detektor zum Messen des Signalpegels am Eingang des jeweiligen Verstärkungs- bzw. Dämpfungsgliedes und jeweils eine nachfolgende Kontrolleinheit zum Ermitteln des zum jeweiligen Verstärkungs- und/oder Dämpfungsgliedes jeweils gehörigen Verstärkungs- bzw. Dämpfungsfaktors auf. Erfindungsgemäß ist jede Kontrolleinheit als Vorwärts-Steuerungseinheit realisiert, die den zum jeweiligen Verstärkungs- und/oder Dämpfungsglied jeweils gehörigen Verstärkungs- bzw. Dämpfungsfaktor einzig in Abhängigkeit des gemessenen

Signalpegels des am Eingang des jeweiligen Verstärkungs- und/oder Dämpfungsgliedes anliegenden Signals ermittelt. Weiterhin ist einer zum Verstärkungsglied gehörigen Kontrolleinheit jeweils ein Multiplizierer zum Gewichten des vom Detektor am Eingang des jeweiligen Verstärkungsgliedes gemessenen Signalpegels mit einem Gewichtungsfaktor, der der Steigung der zur Kontrolleinheit gehörigen Übertragungskennlinie entspricht, und jeweils ein Addierer zum Addieren eines derart gewichteten Signalpegels mit einem Versatzwert (Offset-Wert), der dem Ordinatenachsenwert der zur jeweiligen Kontrolleeinheit gehörigen Übertragungskennlinie entspricht, vorgesehen.

Die Übertragungskennlinie der zum Verstärkungsglied gehörigen Kontrolleinheit lässt sich aus der Übertragungskennlinie des zugehörigen Detektors und der Übertragungskennlinie des zugehörigen Verstärkungsgliedes ermitteln.

Gemäß einem Beispiel ist in der Kontrolleinheit ein Speicher vorgesehen, dessen Speicherzellen jeweils in Abhängigkeit des Abszissenwertes der Übertragungskennlinie der Kontrolleinheit, das heißt in Abhängigkeit des vom Detektor am Eingang des jeweiligen Verstärkungsgliedes anliegenden und in einen linearen Maßstab abbildenden Signalpegels, adressierbar sind und dessen adressierter Speicherzellen-Inhalt, das heißt der zugehörige Verstärkungsfaktor, an dem Ausgang der Kontrolleinheit auslesbar ist.

Die Übertragungskennlinie der zu einem Dämpfungsglied gehörigen Kontrolleinheit lässt sich vorzugsweise aus der Übertragungskennlinie des zugehörigen Detektors, die ein im logarithmischen Maßstab erfassten Signalpegel des am Eingang des jeweiligen Dämpfungsgliedes anliegenden Signals in ein am Ausgang des Detektors anliegendes, im linearen Maßstab vorliegendes Signal transformiert, und die einzelnen in den Dämpfungsgliedern einzustellenden Dämpfungsfaktoren ermitteln.

Die zum Dämpfungsglied gehörige Kontrolleinheit weist hierzu bevorzugt einen Zustandsautomaten auf, der für jeden im Dämpfungsglied realisierbaren Dämpfungsfaktor jeweils einen Zustand hat. Im jeweiligen Zustand verharrt der Zustandsautomat, solange das am Ausgang des Detektors anliegende Signal in einem zum Zustand gehörigen Signalpegelbereich liegt. Falls der am Ausgang des Detektors anliegende Signalpegel den zum Zustand gehörigen Signalpegelbereich verlässt, erfolgt eine Umschaltung in einen der beiden benachbarten Zustände. Die Übergänge zwischen den einzelnen Zuständen des Zustandsautomats erfolgen bevorzugt mittels einer Hysterese-Charakteristik. Die erfindungsgemäße Vorrichtung zum automatischen Einstellen eines Verstärkung- bzw. Dämpfungsfaktors von kaskadierten Verstärkungsgliedern oder von mehreren in Kaskade verschalteten Verstärkungs- und Dämpfungsgliedern wird im Folgenden anhand der Zeichnung im Detail erläutert. Die Figuren der Zeichnung zeigen:
- Fig. 1: ein Blockdiagramm eines empfangsseitigen Signalpfades eines Funkgeräts bei welchen die Erfindung Anwendung findet,
- Fig. 2A, 2B: ein beispielhaftes Diagramm mit der Übertragungskennlinie eines Detektors und der Übertragungskennlinie eines Verstärkungsgliedes,
- Fig. 3A, 3B: Fig. 3A ein beispielhaftes Blockdiagramm einer nicht erfindungsgemäßen und Fig. 3B ein beispielhaftes Blockdiagramm einer erfindungsgemäßen, zu einem Verstärkungsglied gehörigen Kontrolleinheit,
- Fig. 4: ein beispielhaftes Blockdiagramm einer erfindungsgemäßen, zu einen Dämpfungsglied gehörigen Kontrolleinheit,
- Fig. 5: ein beispielhaftes Zustandsdiagramm zur Ermittlung eines Dämpfungsfaktors für ein Dämpfungsglied in einer erfindungsgemäßen, zu einen Dämpfungsglied gehörigen Kontrolleinheit und
- Fig. 6A,6B: ein beispielhaftes Diagramm mit der Übertragungskennlinie einer zum Verstärkungsglied gehörigen Kontrolleinheit und einer zum Dämpfungsglied gehörigen Kontrolleinheit.

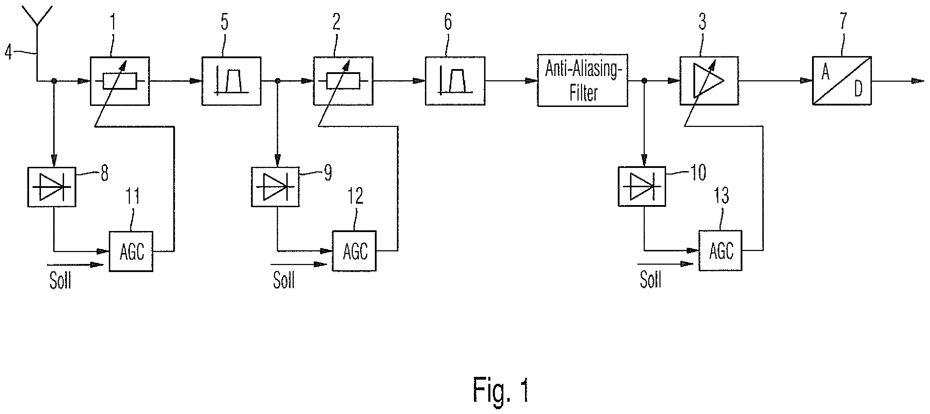

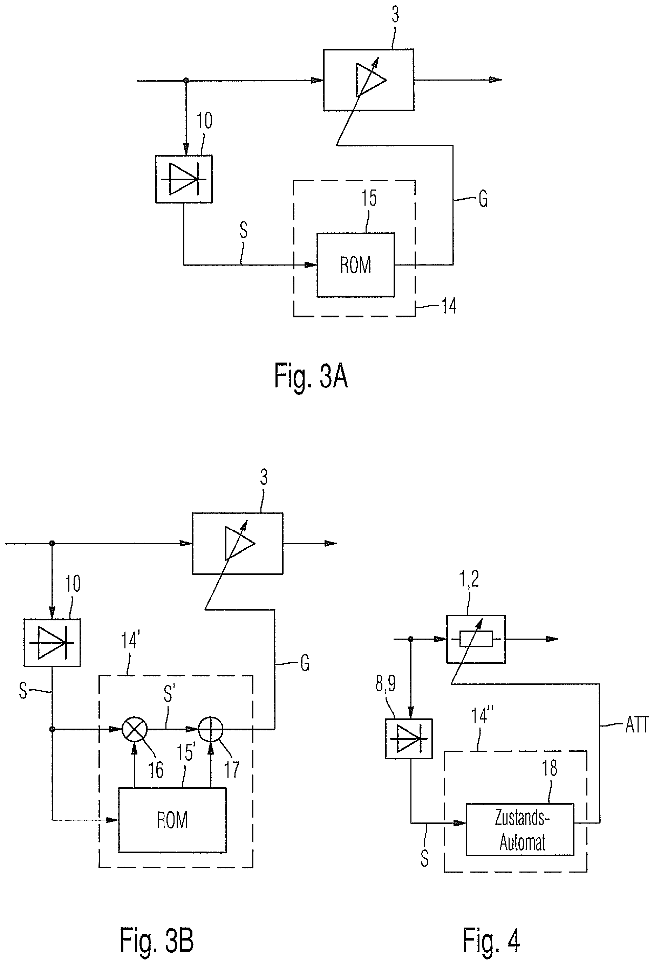

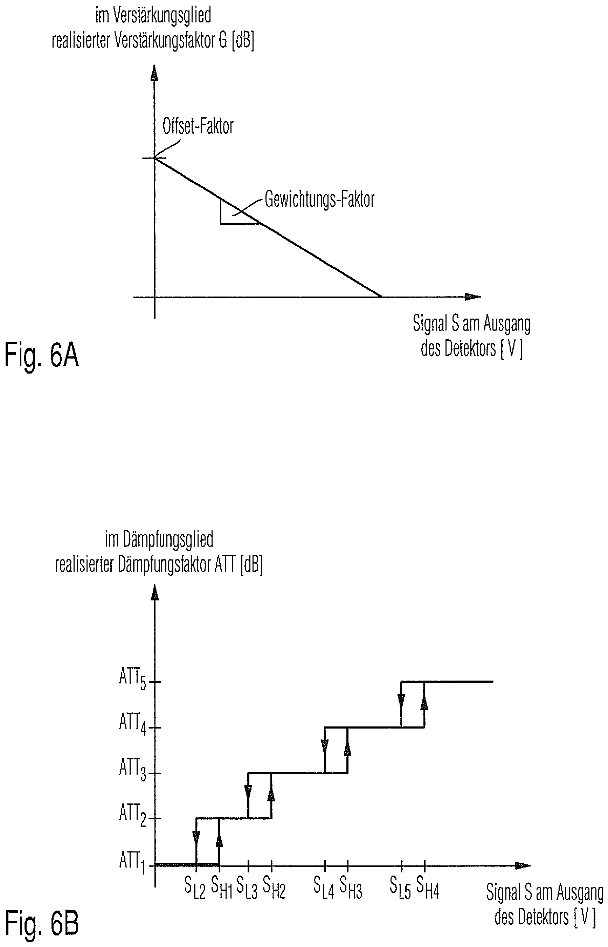

Im Signalpfad eines Funkgeräts von der Antenne bis zum Analog-Digital-Wandler gemäß Fig. 1 werden schaltbare Dämpfungsglieder 1 und 2 bzw. einstellbare Verstärker 3 eingefügt, welche sicher stellen, dass das von einer Antenne 4 empfangene Signal des Funksignals in dem vorhandenen Dynamikbereich der einzelnen Signalverarbeitungseinheiten im Funkgerät, bestehend z.B. aus dem Hochfrequenz-Selektionsfilter 5, dem Zwischenfrequenz-Selektionsfilter 6, dem Analog-Digital-Wandler 7, verarbeitet werden kann. Die Einstellung des Verstärkungs- bzw. Dämpfungsfaktors der einzelnen Verstärker- bzw. Dämpfungsstufen 1, 2 und 3 erfolgt nach einer Messung des Signalpegels am Eingang der jeweiligen Verstärkungs- bzw. Dämpfungsstufe 1, 2 und 3 mittels eines zugeordneten Detektors 8, 9 und 10 in einer zugeordneten automatischen Verstärkungssteuerung (Automatic Gain Control (AGC)) 11, 12 und 13.Eine nicht erfindungsgemäße Kontrolleinheit 14 zur Ermittlung eines Verstärkungsfaktors für ein Verstärkungsglied 3, das heißt für einen hinsichtlich seines Verstärkungsfaktors G einstellbaren Verstärker, besteht gemäß Fig. 3A aus einem Speicher 15, der bevorzugt als Festwertspeicher (Read-Only-Memery (ROM)) ausgeführt ist. In den einzelnen Speicherzellen des Speichers 15 sind die in einem äquidistanten Raster ausgeführten Werte des Verstärkungsfaktors G für das Verstärkungsglied 13 abgelegt. Die einzelnen Speicherzellen des Speichers 15 sind in Abhängigkeit des Signalpegels des am Ausgang des Detektors 10 anliegenden Signals adressierbar. Auf diese Weise weist die durch den Speicher 15 realisierte Kontrolleinheit 14 eine Übertragungskennlinie zwischen dem im linearen Maßstab vorliegenden Signalpegel des Signals S am Ausgang des Detektors 10 und dem im Verstärkungsglied 3 im logarithmierten Maßstab eingestellten Verstärkungsfaktor G gemäß Fig. 6A auf.

Die erfindungsgemäße Kontrolleinheit 14' zur Ermittlung eines Verstärkungsfaktors G für ein Verstärkungsglied 3 besteht gemäß Fig. 3B aus einer Serienschaltung eines bevorzugt digitalen Multiplizierers 16 und eines bevorzugt digitalen Addierers 17. Im Multiplizierer 16 wird das im linearen Maßstab vorliegende Signal S am Ausgang des Detektors 10 mit einem in einem Speicher 15', bevorzugt einem Festwertspeicher, abgelegten Gewichtsfaktor gewichtet, der gemäß Fig. 6A der Steigung der Übertragungskennlinie der Kontrolleinheit 14 bzw. 14' entspricht. Das mit dem Gewichtsfaktor gewichtete Signal S' wird im anschließenden Addierer 17 zu einem im Speicher 15' abgelegten Offsetwert (Versatzwert) addiert, der gemäß Fig. 6A dem Ordinatenachsenwert der Übertragungskennlinie der Kontrolleinheit 14 bzw. 14' entspricht. Die den jeweiligen Gewichtungsfaktor und Offsetwert speichernden Speicherzellen des Speichers 15' werden über den Signalpegel des am Ausgang des Detektors 10 anliegenden Signals adressiert. Somit wird mit der Ausführungsform einer erfindungsgemäßen Kontrolleinheit 14' ebenfalls eine Übertragungskennlinie zwischen dem im linearen Maßstab vorliegenden Signalpegel des Signals S am Ausgang des Detektors 10 und dem im Verstärkungsglied 3 im logarithmierten Maßstab eingestellten Verstärkungsfaktor G gemäß Fig. 6A realisiert.

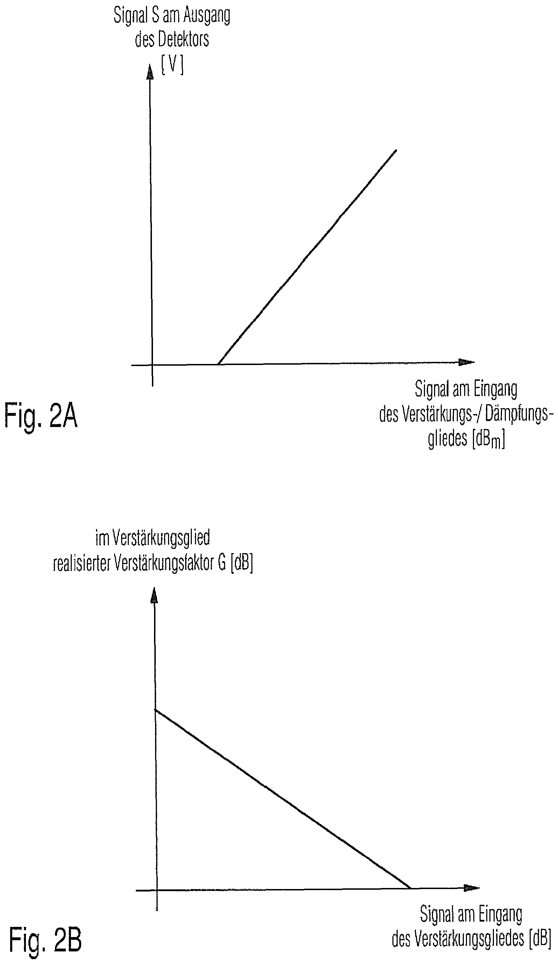

Sowohl die für das Beispiel einer nicht erfindungsgemäßen Kontrolleinheit 14 in den Speicherzellen des Speichers 15 jeweils abgelegten Verstärkungsfaktor-Werte als auch die für die Ausführungsform einer erfindungsgemäßen Kontrolleinheit 14' in den Speicherzellen des Speichers 15' jeweils abgelegten Gewichtungsfaktoren und Offsetwerte werden vorab durch Messung der Übertragungskennlinie des Detektors 10 zwischen dem im logarithmierten Maßstab gemessenen Signal am Eingang des Verstärkungsgliedes 3 und dem im linearen Maßstab vorliegenden Signalpegel des am Ausgang des Detektors 10 anliegenden Signals gemäß Fig. 2A und der Übertragungskennlinie des Verstärkungsgliedes 3 zwischen dem im logarithmischen Maßstab gemessenen Signalpegel des am Eingang des Verstärkungsgliedes 3 anliegenden Signals und dem im Verstärkungsglied 3 im logarithmierten Maßstab eingestellten Verstärkungsfaktor G gemäß Fig. 6A ermittelt.

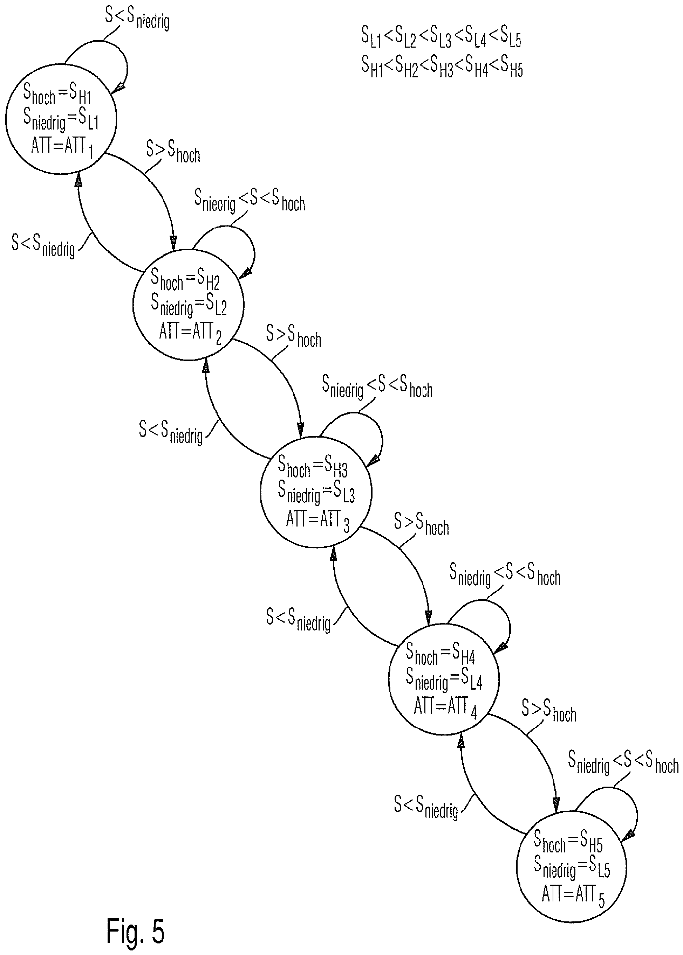

Die erfindungsgemäße Kontrolleinheit 14" zur Ermittlung eines Dämpfungsfaktors ATT für ein Dämpfungsglied 1 bzw. 2 besteht gemäß Fig. 4 bevorzugt aus einem Zustands-Automat 18. Der Zustands-Automat 18 weist eine der Anzahl von im Dämpfungsglied 1 bzw. 2 realisierten Dämpfungsfaktor-Werten entsprechende Anzahl von Zuständen auf. Der zum Zustandsdiagramm in Fig. 5 gehörige Zustands-Automat weist beispielsweise 5 Zustände mit den jeweils zugehörigen Dämpfungsfaktor-Werten ATT₁, ATT₂, ATT₃, ATT₄ und ATT₅ auf. Im Hinblick auf eine feinere Rasterung der im Dämpfungsglied 1 bzw. 2 jeweils einstellbaren Dämpfungsfaktoren ist auch eine höhere Anzahl von Zuständen im Zustands-Automaten 18 verwirklichbar.

Die Auswahl des jeweiligen Zustands des Zustands-Automaten 18 erfolgt anhand des Signalpegels des am Ausgang des Detektors 8 bzw. 9 anliegenden Signals S. Hierzu wird jedem einzelnen Zustand ein Signalpegelbereich des am Ausgang des Detektors 8 bzw. 9 anliegenden Signals gemäß Fig. 5 zugeordnet. Erhöht sich der Signalpegel des am Ausgang des Detektors 8 bzw. 9 anliegenden Signals S über den Signalpegelbereich des aktuellen Zustands, so erfolgt im Zustands-Automat 18 ein Übergang in den benachbarten Zustand, dessen Signalpegelbereich sich oberhalb des Signalpegelbereichs des aktuellen Zustands befindet. Reduziert sich der Signalpegel des am Ausgang des Detektors 8 bzw. 9 anliegenden Signals S unter den Signalpegelbereich des aktuellen Zustands, so geht der Zustands-Automat 18 in den benachbarten Zustand über, dessen Signalpegelbereich sich unterhalb des Signalpegelbereichs des aktuellen Zustands befindet.

Um ein ständiges Schalten des Zustands-Automaten 18 zwischen zwei benachbarten Zuständen im Fall eines verrauschten Signalpegels des am Ausgang des Detektors 8 bzw. 9 anliegenden Signals S im Signalpegelbereich eines Zustands-Übergangs zu vermeiden, weisen die Übergänge zwischen den einzelnen Zuständen des Zustands-Automaten 18 bevorzugt eine Hysterese-Charakteristik auf, wie sie im Zustandsdiagramm der Fig. 5 dargestellt ist.

Auf diese Weise wird mit der erfindungsgemäßen Kontrolleinheit 14" eine Übertragungskennlinie zwischen dem im linearen Maßstab vorliegenden Signalpegel des Signals S am Ausgang des Detektors 8 bzw. 9 und dem im Dämpfungsglied 1 bzw. 2 eingestellten Dämpfungsfaktor ATT gemäß Fig. 6B ermittelt.

Die Erfindung ist nicht auf die dargestellten Ausführungsformen beschränkt, sondern sie wird durch die Ansprüche definiert.

## Patentansprüche

1. Vorrichtung zum automatischen Einstellen eines Verstärkungs- bzw. Dämpfungsfaktors (G;ATT) von mehreren in Kaskade verschalteten Verstärkungsgliedern (3) oder von mehreren in Kaskade verschalteten Verstärkungs- und Dämpfungsgliedern (1;2;3) mit für jedes Verstärkungs- bzw. Dämpfungsglied jeweils einem Detektor (8;9;10) zum Messen eines Signalpegels eines am Eingang des jeweiligen Verstärkungs- oder Dämpfungsgliedes (1;2;3) anliegenden Signals und jeweils einer nachfolgenden Kontroll-Einheit (14;14';14'") zur Ermittlung des zum jeweiligen Verstärkungs- und/oder Dämpfungsglied (1;2;3) jeweils gehörigen Verstärkungs- bzw. Dämpfungsfaktors (G;ATT),
wobei jede Kontroll-Einheit (14;14';14'') eine Vorwärtssteuerungs-Einheit zur Ermittlung des zum jeweiligen Verstärkungs- und/oder Dämpfungsglied (1;2;3) jeweils gehörigen Verstärkungs- bzw. Dämpfungsfaktors (G;ATT) in Abhängigkeit einzig des gemessenen Signalpegels des am Eingang des jeweiligen Verstärkungs- und/oder Dämpfungsgliedes (1;2;3) anliegenden Signals ist,
**dadurch gekennzeichnet,**
**dass** in der zu einem Verstärkungsglied (3) gehörigen Kontroll-Einheit (14') eine Serienschaltung eines Multiplizierers (16) und eines Addierers (17) vorhanden ist, wobei die Kontrolleinheit so konfiguriert ist, dass ein zum Gewichten des Signals am Ausgang des Detektors (10) im Multiplizierer (16) erforderlicher Gewichtsfaktor, der der Steigung der zur Kontroll-Einheit (14') gehörigen Übertragungskennlinie entspricht, und ein zur Addition des gewichteten Signals im Addierer (17) erforderlicher Versatzwert, der dem Ordinatenachsenwert der zur Kontroll-Einheit (14') gehörigen Übertragungskennlinie entspricht, jeweils in einer Speicherzelle eines Speichers (15') abgelegt sind, die über den Signalpegel des am Ausgang des Detektors (10) anliegenden Signals adressierbar sind.

2. Vorrichtung nach Anspruch 1,
**dadurch gekennzeichnet,**
**dass** die Übertragungskennlinie der zu einem Verstärkungsglied (3) gehörigen Kontroll-Einheit (14;14') in Abhängigkeit der Übertragungskennlinie des jeweiligen Detektors (10) zwischen dem gemessenen Signalpegel des am Eingang des jeweiligen Verstärkungsgliedes (3) anliegenden Signals und dem am Ausgang des jeweiligen Detektors (10) ausgegebenen Signalpegel und der Übertragungskennlinie des jeweiligen Verstärkungsgliedes (3) zwischen dem Signalpegel des am Eingang des Verstärkungsgliedes (3) anliegenden Signals und dem im Verstärkungsglied (3) eingestellten Verstärkungsfaktor (G) ermittelt wird.

3. Vorrichtung nach Anspruch 2,
**dadurch gekennzeichnet,**
**dass** im Falle mehrerer in Kaskade verschalteter Verstärkungs- und Dämpfungsglieder (1;2;3) die Übertragungskennlinie der zu einem Dämpfungsglied (1;2) gehörigen Kontroll-Einheit (14") in Abhängigkeit der Übertragungskennlinie des jeweiligen Detektors (8;9) zwischen dem gemessenen Signalpegel des am Eingang des jeweiligen Dämpfungsgliedes (1;2) anliegenden Signals und dem am Ausgang des jeweiligen Detektors (8;9) ausgegebenen Signalpegel sowie den einzelnen vom Dämpfungsglied (1;2) realisierbaren Dämpfungsfaktoren (ATT₁, ATT₂, ATT₃, ATT₄, ATT₅) ermittelt wird.

4. Vorrichtung nach Anspruch 3,
**dadurch gekennzeichnet,**
**dass** im Falle mehrerer in Kaskade verschalteter Verstärkungs- und Dämpfungsglieder (1;2;3) die zu einem Dämpfungsglied (1;2) gehörige Kontroll-Einheit (14") als Zustands-Automat (18) realisiert ist, in dem für jeden im Dämpfungsglied (1;2) realisierbaren Dämpfungsfaktor (ATT₁, ATT₂, ATT₃, ATT₄, ATT₅) jeweils ein Zustand vorgesehen ist, in dem der Zustands-Automat (18) für einen zugehörigen Bereich des am Ausgang des jeweiligen Detektors (8;9) ausgegebenen Signalpegels verharrt.

5. Vorrichtung nach Anspruch 4,
**dadurch gekennzeichnet,**
**dass** im Falle mehrerer in Kaskade verschalteter Verstärkungs- und Dämpfungsglieder (1;2;3) die Übergänge zwischen den einzelnen Zuständen des Zustands-Automaten (18) eine Hysterese-Charakteristik aufweisen.

## Claims

1. Device for automatic adjustment of an amplifying or attenuating factor (G; ATT) of a plurality of amplifying members (3) connected in cascade or of a plurality of amplifying and attenuating members (1; 2; 3) connected in cascade with in each case for each amplifying or attenuating member a detector (8; 9; 10) for measuring a signal level of a signal present at the input of the respective amplifying or attenuating member (1; 2; 3) and in each case a following control unit (14; 14'; 14") for determining the amplifying or attenuating factor (G; ATT) associated with the respective amplifying and/or attenuating member (1; 2; 3) in each case, wherein each control unit (14; 14'; 14") is a forward control unit for determining the amplifying or attenuating factor (G; ATT) associated with the respective amplifying and/or attenuating member (1; 2; 3) depending solely on the measured signal level of the signal present at the input of the respective amplifying and/or attenuating member (1; 2; 3), **characterised in that** the control unit (14') associated with an amplifying member (3) contains a series circuit of a multiplier (16) and an adder (17), wherein the control unit is configured so that a weighting factor which is required for weighting the signal at the output of the detector (10) in the multiplier (16) and corresponds to the gradient of the transmission characteristic associated with the control unit (14'), and an offset value which is required for adding the weighted signal in the adder (17) and corresponds to the ordinate axis value of the transmission characteristic associated with the control unit (14') are each stored in a memory cell of a memory (15') which can be addressed by means of the signal level of the signal present at the output of the detector (10).

2. Device according to claim 1,
**characterised in that** the transmission characteristic of the control unit (14; 14') associated with an amplifying member (3) is determined depending on the transmission characteristic of the respective detector (10) between the measured signal level of the signal present at the input of the respective amplifying member (3) and the signal level outputted at the output of the respective detector (10) and the transmission characteristic of the respective amplifying member (3) between the signal level of the signal present at the input of the amplifying member (3) and the amplifying factor (G) set in the amplifying member (3).

3. Device according to claim 2,
**characterised in that** in the case of a plurality of amplifying and attenuating members (1; 2; 3) connected in cascade the transmission characteristic of the control unit (14") associated with an attenuating member (1; 2) is determined depending on the transmission characteristic of the respective detector (8; 9) between the measured signal level of the signal present at the input of the respective attenuating member (1; 2) and the signal level outputted at the output of the respective detector (8; 9) and the individual attenuating factors (ATT₁, ATT₂, ATT₃, ATT₄, ATT₅) which can be produced by the attenuating member (1; 2).

4. Device according to claim 3,
**characterised in that** in the case of a plurality of amplifying and attenuating members (1; 2; 3) connected in cascade the control unit (14") associated with an attenuating member (1; 2) is embodied in the form of a state machine (18) in which in each case a state is provided for each attenuating factor (ATT₁, ATT₂, ATT₃, ATT₄, ATT₅) which can be produced in the attenuating member (1; 2) in which state the state machine (18) remains for an associated range of the signal level outputted at the output of the respective detector (8; 9).

5. Device according to claim 4,
**characterised in that** in the case of a plurality of amplifying and attenuating members (1; 2; 3) connected in cascade the transitions between the individual states of the state machine (18) have a hysteresis characteristic.

## Revendications

1. Dispositif de réglage automatique d'un facteur d'amplification ou d'atténuation (G ; ATT) de plusieurs organes d'amplification (3) couplés en cascade ou de plusieurs organes d'amplification et d'atténuation (1 ; 2 ; 3) couplés en cascade avec pour chaque organe d'amplification ou d'atténuation un détecteur (8 ; 9 ; 10) respectif pour la mesure du niveau de signal d'un signal appliqué à l'entrée de l'organe d'amplification ou d'atténuation (1 ; 2 ; 3) respectif et une unité de contrôle (14 ; 14' ; 14") respective en aval pour la détermination de chaque facteur d'amplification ou d'atténuation (G ; ATT) relevant de l'organe d'amplification et/ou d'atténuation (1 ; 2 ; 3) respectif, dans lequel chaque unité de contrôle (14 ; 14' ; 14") est une unité de commande à action directe pour la détermination de chaque facteur d'amplification ou d'atténuation (G ; ATT) relevant de l'organe d'amplification et/ou d'atténuation (1 ; 2 ; 3) respectif en fonction uniquement du niveau de signal mesuré du signal appliqué à l'entrée de l'organe d'amplification et/ou d'atténuation (1 ; 2 ; 3) respectif,
**caractérisé**
**en ce qu'**un montage en série d'un multiplicateur (16) et d'un sommateur (17) est présenté dans l'unité de contrôle (14') relevant d'un organe d'amplification (3), dans lequel l'unité de contrôle est configurée de telle manière qu'un facteur de pondération exigé pour la pondération du signal à la sortie du détecteur (10) dans le multiplicateur (16), lequel correspond à la pente de la courbe caractéristique de transmission relevant de l'unité de contrôle (14'), et qu'une valeur de décalage exigée pour l'addition du signal pondéré dans le sommateur (17), laquelle correspond à la valeur de l'axe des ordonnées de la courbe caractéristique de transmission relevant de l'unité de contrôle (14'), sont respectivement sauvegardés dans une cellule d'une mémoire (15'), et adressables au moyen du niveau de signal du signal appliqué à la sortie du détecteur (10).

2. Dispositif selon la revendication 1,
**caractérisé**
**en ce que** la courbe caractéristique de transmission de l'unité de contrôle (14 ; 14') relevant d'un organe d'amplification (3) est déterminée en fonction de la courbe caractéristique de transmission du détecteur (10) respectif entre le niveau de signal mesuré du signal appliqué à l'entrée de l'organe d'amplification (3) respectif et le niveau de signal émis à la sortie du détecteur (10) respectif et de la courbe caractéristique de transmission de l'organe d'amplification (3) respectif entre le niveau de signal du signal appliqué à l'entrée de l'organe d'amplification (3) et le facteur d'amplification (G) réglé dans l'organe d'amplification (3).

3. Dispositif selon la revendication 2,
**caractérisé**
**en ce que** dans le cas de plusieurs organes d'amplification et d'atténuation (1 ; 2 ; 3) couplés en cascade, la courbe caractéristique de transmission de l'unité de contrôle (14") relevant d'un organe d'atténuation (1 ; 2) est déterminée en fonction de la courbe caractéristique de transmission du détecteur (8 ; 9) respectif entre le niveau de signal mesuré du signal appliqué à l'entrée de l'organe d'amplification (1 ; 2) respectif et le niveau de signal émis à la sortie du détecteur (8 ; 9) respectif, et en fonction des différents facteurs d'atténuation (ATT1, ATT2, ATT3, ATT4, ATT5) réalisables par l'organe d'atténuation (1 ; 2).

4. Dispositif selon la revendication 3,
**caractérisé**
**en ce que** dans le cas de plusieurs organes d'amplification et d'atténuation (1 ; 2 ; 3) couplés en cascade, l'unité de contrôle (14") relevant d'un organe d'atténuation (1 ; 2) est réalisée comme automate d'état (18), où un état est prévu pour chaque facteur d'atténuation (ATT1, ATT2, ATT3, ATT4, ATT5) réalisable dans l'organe d'atténuation (1 ; 2), état dans lequel l'automate d'état (18) reste fixé pour une plage correspondante du niveau de signal émis à la sortie du détecteur (8 ; 9) respectif.

5. Dispositif selon la revendication 4,
**caractérisé**
**en ce que** dans le cas de plusieurs organes d'amplification et d'atténuation (1 ; 2 ; 3) couplés en cascade, les passages entre les différents états de l'automate d'état (18) présentent une caractéristique d'hystérèse.
